# EUROPEAN PATENT APPLICATION

(11) **EP 4 098 770 A1**
(43) Date of publication of application: **07.12.2022**
(21) Application number: 21177315.5
(22) Date of filing: 02.06.2021
(51) Int. Cl.: C23C 28/04, C23C 30/00, C23C 16/56

(54) **A COATED CUTTING TOOL**

(71) Applicant: Pramet Tools, S.R.O., 787 53 Sumperk (CZ)
(72) Inventor: FLASAR, Petr, Sumperk (CZ); VORTEL, Ondrej, Sumperk (CZ)
(74) Representative: Sandvik

(57) **Abstract**

The present invention relates to a coated cutting tool. The cutting tool is CVD coated and the substrate is made of cemented carbide. The CVD coating comprises an inner layer of TiN and a subsequent layer of TiCN and a layer of Al₂O₃. The coated cutting tool is subjected to a shot peening process using a granular media comprising beads of crystallin tungsten carbide. The present invention also relates to a method of shot peening coated cutting tools with beads of crystallin tungsten carbide.

## Description

### TECHNICAL FIELD

The present invention relates to a coated cutting tool comprising a substrate and a coating, wherein the cutting tool have been subjected to a shot peening process using a peening media of crystallin tungsten carbide.

### BACKGROUND

Coated cutting tools for metal cutting are well known in the art of cutting tools and common coatings are deposited by chemical vapor deposition (CVD) and physical vapor deposition (PVD). The substrate body of the cutting tool is usually made of cemented carbide.

Dry blasting or shot peening of coated cutting tools are known in the art to increase the performance of the tool by impacting the residual stress in the coating and the substrate and thereby positively affect the resistance to wear especially in intermittent cutting applications.

It is an object of the present invention to find an improved dry blasting method and also to provide coated cutting tools with increased resistance to wear during metal cutting.

### DESCRIPTION OF THE INVENTION

At least one of the above-mentioned objects is achieved by a method according to claim 1 and a cutting tool according to claim 9. Preferred embodiments are disclosed in the dependent claims.

The present invention relates to a method of treating a coated cutting tool, said cutting tool comprise a cemented carbide substrate and a coating. The method comprises a step of subjecting at least a part of the cutting tool to a shot peening treatment using a peening media. The cutting tool comprises a rake face, a flank face and a cutting edge there between, wherein said peening media comprise beads of crystallin tungsten carbide. The shape of the beads is spherical. The crystallin tungsten carbide can be WC, WC₁₋ₓ or W₂C, alone or in any combination. By crystallin is herein meant that when beads or fragments of beads are analysed in X-ray diffraction (XRD), clear diffraction peaks can be identified. The apparent or filling density of the media is preferably between 9.5 - 11 g/cm³. The impurity level in the beads of crystallin tungsten carbide is preferably less than 0.7 wt%. The hardness of the beads is preferably 3400-3700 HV0.05. The beads are preferably MetaX^{®}.

It was surprisingly found that crystallin tungsten carbide as a peening media for peening coated cutting tools was unexpectedly promising, resulting in cutting tools with prolonged lifetimes. The unexpected response in the coated cutting tool from the shot peening with crystallin tungsten carbide is believed to be due to the unique combination of a very high density and a very high stiffness of the tungsten carbide material.

In one embodiment of the present invention an ER of at least a part of said cutting edge is 25-70 µm, preferably 40-60 µm, more preferably 50-55 µm. It has surprisingly been shown that the cutting tools made according to present method is performing well on cutting tools with this ER.

In one embodiment of the present invention said shot peening is performed at least on the rake face of the cutting tool.

In one embodiment of the present invention the shot peening is performed with a peening media of beads with an average diameter of 45-125 µm. If the beads are too large the risk of damaging the cutting edge is increased. If the beads are too small the energy and impact transferred from the media to the substrate and coating is less pronounced.

In one embodiment of the present invention the average diameter of the beads is 80-100 µm.

In one embodiment of the present invention peening is applied in a direction perpendicular to the surface of the coated cutting tool.

In one embodiment of the present invention the coating comprises a TiCN layer and an α-Al₂O₃- layer. The coating can also comprise an inner and/or outer layer of for example TiN. The thickness of the TiCN layer is preferably 8-12 µm and the thickness of the α-Al₂O₃- layer is preferably 4-8 µm.

In one embodiment of the present invention the shot peening is followed by a shot blasting step, preferably applied on the same surface(s) of the cutting tool. By making the shot blasting subsequent to the shot peening, effects of the shot blasting can improve the performance of the cutting tool. If the shot peening is made subsequent to the shot blasting, the advantages in residual stress changes from the shot blasting is partially removed. So it is advantageous to do the shot peening first and there after the shot blasting. Shot blasting is also advantageous in that it can be used to clean the outer surface of the cutting tool from any residuals or debris of tungsten carbide left on the surfaces after the shot peening process. Shot blasting can also be used to smoothen the outer surface of the cutting tool, i.e. reduce the surface roughness.

In one embodiment of the present invention the peening pressure during the shot peening is 1-3 bar.

The present invention also relates to a cutting tool comprising a substrate of cemented carbide and a coating, wherein the cutting tool comprise a rake face (1), a flank face (2) and a cutting edge (3) there between, wherein the coating comprises in the order from the substrate a TiCN layer, an α-Al₂O₃-layer, wherein the thickness of the TiCN layer is 8-12 µm and the thickness of the α-Al₂O₃-layer is 4-8 µm, wherein the residual stress in said TiCN layer as measured with X-ray diffraction (XRD) by a sin²_{Ψ} with integral analyse depth using the(422) peak is between 0 MPa and +100 MPa, preferably between +5 MPa and +75 MPa, and wherein the residual stress in said α-Al₂O₃- layer as measured with XRD by a sin²_{Ψ} with a fix analyse depth of 2.5 µm from the outer surface of the α-Al₂O₃- layer using the (116) peak is between -1000 MPa and -2500 MPa, preferably between -1100 MPa and -2100 MPa.

It was surprisingly found that a TiCN layer below an α-Al₂O₃-layer was highly influenced by the shot peening of the present invention. The high impact on the residual stress in the TiCN might be due to the very high weight of the tungsten carbide media, and that the transformation of energy therefore can reach the TiCN layer even though it is positioned below the α-Al₂O₃-layer. This high impact on the TiCN layer has not been noticed for any other peening media while still leaving the α-Al₂O₃-layer intact without chipping areas.

In one embodiment of the present invention the ER of at least a part of said cutting edge is 25-70 µm, preferably 40-60 µm, more preferably 50-55 µm.

In one embodiment of the present invention the cemented carbide in the substrate comprise 5-8 wt% Co.

In one embodiment of the present invention the absolute value of the difference Δ between the residual stress in TiCN in the cutting tool at room temperature and the residual stress in TiCN of the same cutting tool after being subjected to a heat treatment in 1030°C in Ar for 3 hours is > 100 MPa, preferably > 200 MPa.

In one embodiment of the present invention the cutting tool comprises a rake face, a flank face and a cutting edge there between, and wherein said shot peening is performed at least on the rake face. Rake face peening is advantageous in that the rake face is subjected to a hit by the workpiece material during the cutting operation. It is further advantageous to apply the shot peening at the rake face since for many cutting tool geometries several cutting edges can be treated at the same time.

In one embodiment of the present invention the metallic binder phase content in the cemented carbide or cermet is 1-30 vol%, preferably 3-25 vol%. The binder phase content is to be high enough to provide a tough behavior of the cutting tool. The metallic binder phase content is preferably not higher than 30 vol%, more preferably not higher than 25 vol%. A too high content of binder phase reduces the hardness and wear resistance of the cutting tool.

Still other objects and features of the present invention will become apparent from the following description considered in conjunction with the accompanying drawings.

### DEFINITIONS

Cemented carbide is a material comprising hard constituents distributed in a continuous metallic binder phase. This kind of material has properties combining a high hardness from the hard constituents with a high toughness from the metallic binder phase and are suitable as substrate materials for metal cutting tools.

By "cemented carbide" is herein meant a material that comprises at least 50 wt% WC, possibly other hard constituents common in the art of making cemented carbides and a metallic binder phase preferably Co and possibly one or more of Fe and Ni.

The metallic binder of the cemented carbide can comprise other elements that are dissolved in the metallic binder during sintering, such as Wand C originating from the WC. Depending on what other types of hard constituents that are present, also other elements can be dissolved in the binder.

By "cutting tool" is herein meant a cutting tool for metal cutting applications such as an indexable cutting insert, an end mill or a drill. The application areas can be turning, milling or drilling.

"ER" is a value of the edge rounding intended to indicate the sharpness of the edge. Larger values of ER represent a rougher shape of the cutting edge while a smaller value of ER represent a sharp cutting edge. ER is herein defined as a value as calculated according to the following:
- put the cutting tool on a flat surface on its bearing surface or the corresponding surface of the cutting tool.
- align a first plane along the side of the cutting tool perpendicular to said flat surface, in contact with the edge to measure, for example along the flank face 3 of the cutting tool 1,
- align a second plane in parallel with said flat surface and intersecting at an intersection point said first plane, said second plane being in contact with the edge to measure at a contact point, for example said second plane is aligned along the rake face 2 of the cutting tool 1.

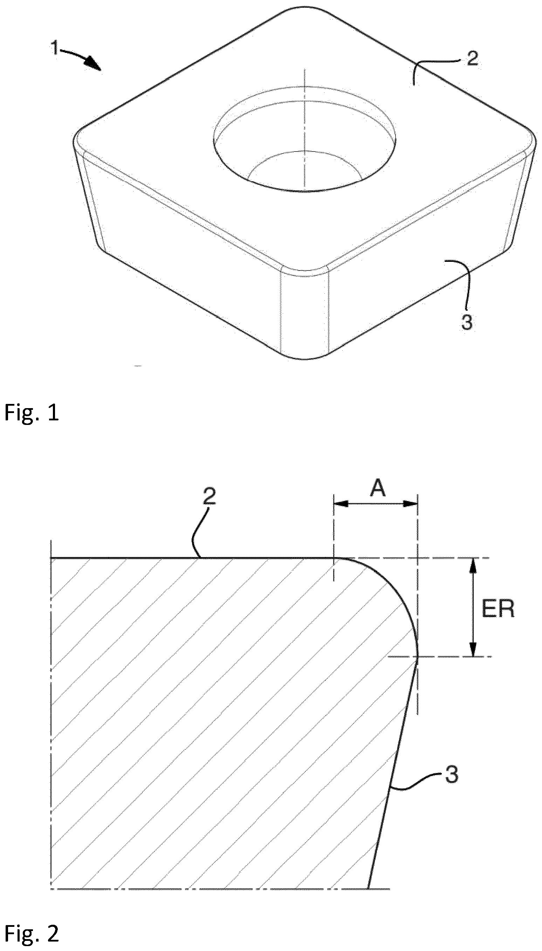

The value "ER" is equal to the distance between the intersection point between the first and the second plane and the point of contact between the first plane and the cutting tool, close to the edge, see Fig. 1 and Fig. 2.

"Shot blasting" is herein denoted a process using abrasive grains wherein material typically is removed from the treated surface by abrasive wear. Shot blasting is well known in the field of cutting tools and is for example known to introduce residual stresses in a coating on a cutting tool.

By "shot peening" is herein meant that the surface of a cutting tool is bombarded with a media comprising particles, so called beads, that are non-abrasive and that typically have a spherical shape. The media used in the present invention is beads of crystallin tungsten carbide.

### METHODS

The residual stress in the layers of the coating and in the substrate was herein analyzed with an X-ray diffractometer, Bruker D8 ADVANCED using the sin²_{Ψ} method. The analyses were made with Cu radiation. Polycapillary optic system without collimator was used for the Ti(C,N) analyses and 2 mm collimator was used for the Al₂O₃ analyses. The equatorial soller slit was 0.3°, LynxEye XE-T detector in 0D mode was used.

During the stress measurement of the Ti(C,N) layer the 422 reflection was used. Side inclination of the sample was selected and the informational depth was integral.

The Al₂O₃ layers were investigated with combined omega-phi-chi method, described in "A method for non-destructive analysis of gradients of mechanical stresses by X-ray diffraction measurements at fixed penetration/information depths" by Kumar et al, J. Appl. Cryst. (2006), 39, 633-646. Side inclination of the sample and a constant informational depth of 2.5 µm was used. The 116 reflection was used for the investigation.

The evaluation of the residual stress data was performed with Bruker software Leptos 7.9. Data was corrected for polarization and Ka2 radiation. Pearson VII peak fitting was used and the X-ray Elastic Constants (XEC) S1 and S2 shown in Table 1.

**Table 1.**

| Phase | Peak | S1.10-7 [MPa⁻¹] | 1/2S2.10-6 [MPa⁻¹] | Depth info. [µm] |
|---|---|---|---|---|
| Al₂O₃ | (116) | -6.138 | 3.171 | 2.5 µm |
| Ti(C,N) | (422) | -4.539 | 2.701 | Integral inf. |

### BRIEF DESCRIPTION OF DRAWINGS

Embodiments of the invention will be described with reference to the accompanying drawings, wherein:
FIG. 1 is a general drawing of a cutting tool with a rake face, a flank face and a cutting edge,
FIG. 2 is a general drawing of a cutting tool showing the intersection point,

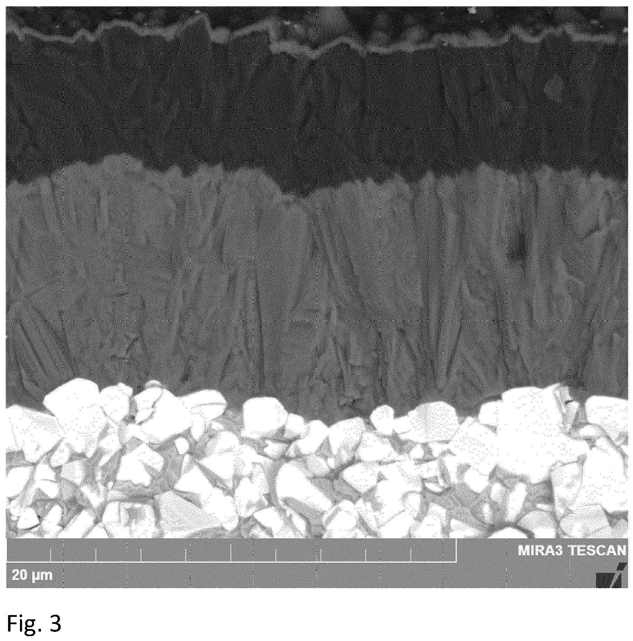

FIG. 3 is a cross-sectional SEM micrograph showing the TiCN layer and the α-Al₂O₃ layer of a coated cutting tool according to one embodiment of the invention (Sample D), appearance on sintered surface,

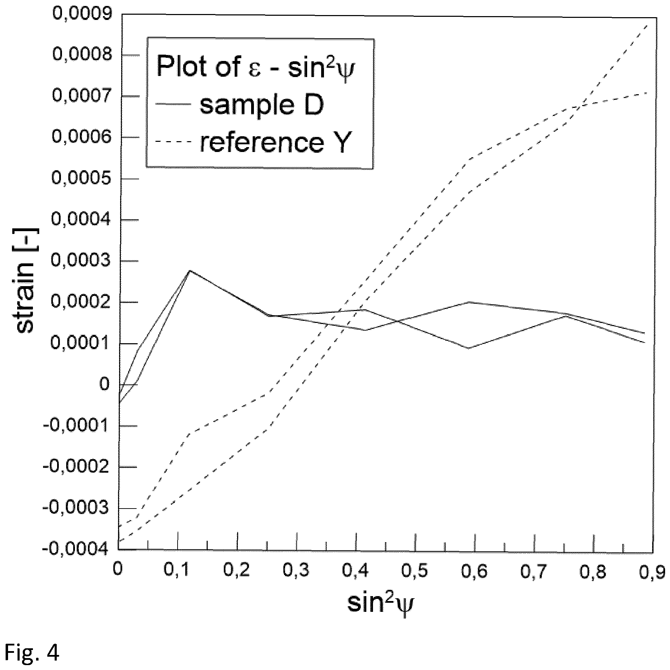

FIG. 4 is a strain - sin²_{Ψ} plot that was obtained during XRD stress measurement of sample D and reference sample Y analysing the TiCN layer, and

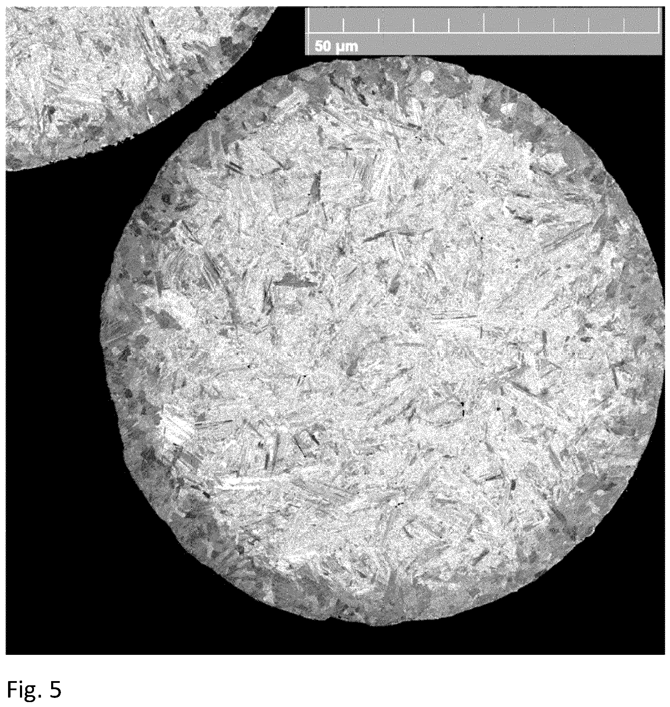

FIG. 5 is a SEM micrograph of blasting media cross-section, etched in Murakami's reagent for 5s.

### EXAM PLES

Embodiments of the present invention will be disclosed in more detail in connection with the following examples. The examples are to be considered as illustrative and not limiting embodiments. In the following examples coated cutting tools (inserts) were manufactured, analyzed and evaluated in cutting tests.

### Substrate

Cemented carbide substrates of ISO-type CNMG120408 for turning and discs with a diameter of 26 mm and height of 1.5 mm were manufactured.

The cemented carbide substrates were manufactured from a powder mixture with a composition of about 6.6 wt% Co, 2.0 wt% Ti, 3.4 wt% Ta, 2.0 wt% Nb and balance WC. The powder mixture was milled, dried, pressed and sintered at 1450°C. The sintered cemented carbide substrates comprised a Co enriched surface zone from the substrate surface and to a depth of about 20 µm into the body being essentially free from cubic carbides. The sintered cemented carbide substrates comprised about 6.6 wt% Co.

### Coating

CVD coatings were deposited on the cemented carbide substrates. The samples were coated in the same coating process, depositing layers of TiN/TiCN/α-Al₂O₃/TiN with CVD. The inner TiN and TiCN layers were in total about 10 µm and the α-Al₂O₃ layer was about 6 µm. The outer TiN was about 0.3 µm. The total coating thickness was about 16 µm.

The ER of the samples were 50-55 µm.

### Blasting media and Shot Peening process

A blasting media consisting of beads of crystallin tungsten carbide was used in the shot peening operation. The beads were of spherical shape and with a mean diameter of about 100 µm. The product name of the peening media was Meta-X^{®}, produced by Höganäs AB. The beads particle size distribution was about 45 µm - 125 µm.

The shot peening was performed in a custom-made prototype THOR machine equipped with pressurize peening system. The shot gun pressure was set to 1.8 Bar, exposure time of each sample was 10 s. The nozzle TrumptusVario of diameter D = 20 mm and the stand-off distance 100 mm were used. The peening was applied in a direction perpendicular to the rake face of the cutting tools.

The same effect can be achieved in a state of the art Rösler ST 1000 PS machine, an injection blasting system. The machine was provided with four nozzles of diameter 8mm connected to one peening air pressure line. This line of ½" dimension was equipped by precision pressure regulator FESTO MS6-LRP pneumatically controlled by proportional pressure regulator FESTO VPPE-3-1-1/8-10-010-E1. The peening media hopper was elevated to the height of the nozzles to ease the media transportation. The amount of the media consumption has an impact on process result and hence must be set carefully. The stand-off distance was 100 mm, peening time set 10 s. Peening pressure was set to 1,15 Bar. A reasonable setting range for this Rösler machine is 1-1.3 Bar for 4 nozzle system.

The shot gun pressure was set to the selected pressure and the exposure time of each sample was 10 s. During the blasting process, the samples were stationary placed under one nozzle. The nozzle diameter was 8 mm and the stand-off distance was 100 mm. The peening was applied in a direction perpendicular to the rake face of the cutting tools.

Sample Y is a reference with no post treatment and the residual stresses in the coatings are as deposited. Sample X is a reference that is only shot blasted, see description of the process below. Samples A-E were shot peened with different peening pressure settings in the THOR machine.

The residual stress analyses of the TiCN layer and in the α-Al₂O₃ layer were made on the cemented carbide discs and the results are presented in table 2.

**Table 2. Summary of samples**

| Sample | Peening pressure in Thor [Bar] | Rösler estimation of peening pressure [Bar] | Residual stress TiCN [MPa] | Residual stress Al₂O₃ [MPa] |
|---|---|---|---|---|
| X (reference) | no (only blasting) | | 592 | 422 |
| Y(reference) | no | | 506 | 366 |
| A | 1.5 | 0.95 | 177 | -835 |
| B | 1.6 | 1.05 | 144 | -999 |
| C | 1.7 | 1.1 | 70 | -1182 |
| D | 1.8 | 1.15 | 31 | -1618 |
| E | 2 x process 1.8 | 1.25 | 5 | -2005 |

Subsequent to the shot peening and prior to the cutting tests, the cutting tools A-E with geometry CNMG120408 were subjected to a wet shot blasting treatment on the rake face of the cutting tools. The shot blasting was performed with Al₂O₃ abrasive grains with a grain size of 240/280 Mesh. The concentration of blasting media in water was 12 vol% and the pump pressure during blasting was 0.6 bar. The blasting pressure was 2.2 bar, the time of blasting per area was about 5 seconds and the blasting was applied with 55 degrees inclination angle to the rake face of the cutting tool. The distance between the shot gun and the samples (cutting tools) was about 170 mm. The general purpose of this shot blasting was to remove the outer TiN layer on the rake face of the cutting tools of frictional reasons and to remove any WC residuals from the surface of the cutting tools. Cutting tool X was only subjected to cleaning shot blasting (no shot peening). This blasting differs from the above-mentioned blasting only in the air pressure, which was set to 1,2 Bar.

### Annealing

In order to investigate the relaxation behavior of the residual stresses in the layers, a set of samples were subjected to an annealing at 1030°C in 90 mBar Argon environment for 3 hours. The shot peening pressure in the Thor machine was 1.8 Bar, i.e. sample D corresponds to sample G below. Sample F corresponds to sample Y. The shot blasting is set as disclosed above. The results are presented in table 3.

**Table 3.**

| Sample | Residual stress in Al₂O₃ [MPa] | Residual stress in TiCN [MPa] | Δ = difference in residual stress in TiCN before and after annealing [MPa] |
|---|---|---|---|
| F (as deposited) | 342 | 444 | \|444-467\|= 23 |
| G (shot peened) | -1606 | 3 | |
| H (shot peened+ shot blasted) | -1506 | 13 | \|13-249\|= 236 |
| I (shot blasted) | 7 | 407 | \|407-388\|= 19 |
| FX (annealed F) | 285 | 467 | |
| HX (annealed H) | 136 | 249 | |
| IX (annealed I) | 190 | 388 | |

As can be seen in the results of table 3, the shot blasting has a clear influence on the residual stress in the alumina (from 342 MPa for sample F to 7 MPa for sample I), but a very marginal affect on the residual stress in the TiCN (from 444 MPa for sample F to 407 MPa for sample I). The shot peening on the other hand had a clear influence on the residual stress in the both the alumina (from 342 MPa for sample F to -1606 MPa for sample G) and the TiCN (from 342 MPa for sample F to 3 MPa for sample G). The influence on the residual stress in the layers when adding shot blasting to an already shot peened sample is very limited as can be seen when comparing the sample G with the sample H.

From the annealing samples it can be concluded that the annealing transforms the residual stress in the samples to a value similar to the residual stress of the layers as deposited. Residual stresses introduced into the layers from the shot blasting or the shot peening processes are at least partly dissolved with the annealing process of 1030°C in Argon for 3 hours.

### Cutting test

The cutting tools X, A-E were tested in a turning operation with intermittent cut using the following cutting parameters:
V_{c} = 130 m/min
Aₚ = 1 mm
Fᵣₑᵥ = 0,3 mm/rev
   Workpiece = P group (CSN EN 14200, 200HB)
   Cooling = NO
   Geometry = CNMG 120408E-M
   Number of edges tested per sample: 12
The lifetime criterion was set to chipping of at least 0.5 mm of the edge line. Tool life is presented as the average number of cut entrances in order to achieve the criteria. The results are presented in table 4.

**Table 4. Cutting test result**

| Sample | Peening pressure [Bar] | Tool life (average) | Comment |
|---|---|---|---|
| X (reference) | no | 108 | |
| A | 1.5 | 3185 | |
| B | 1.6 | 3368 | |
| C | 1.7 | 6001 | |
| D | 1.8 | 5663 | |
| E | 2x1.8 | 6680 | Edge chipping observed |

As can be seen in the results the samples C, D and E showed a very long average tool life, almost twice as long as the samples A and B. And if the comparison is made with the reference sample X that is not post treated at all, the average life time is increased more than 50 times showing the very high potential with shot peening on cutting tools, and especially shot peening with crystallin tungsten carbide.

While the invention has been described in connection with the above exemplary embodiments, it is to be understood that the invention is not to be limited to the disclosed exemplary embodiments; on the contrary, it is intended to cover various modifications and equivalent arrangements within the appended claims.

## Claims

1. A method of treating a coated cutting tool, said cutting tool comprises a cemented carbide substrate and a coating, said method comprises a step of subjecting at least a part of the cutting tool to a shot peening treatment using a peening media, the cutting tool comprises a rake face, a flank face and a cutting edge there between, wherein said peening media comprise beads of crystallin tungsten carbide.

2. The method in accordance with claim 1 wherein an ER of at least a part of said cutting edge is 25-70 µm, preferably 40-60 µm, more preferably 50-55 µm.

3. The method in accordance with any of the preceding claims, wherein said shot peening is performed at least on the rake face of the cutting tool.

4. The method in accordance with any of the preceding claims, wherein the average diameter of the beads is 45-125 µm, preferably 80-100 µm.

5. The method in accordance with any of the preceding claims, wherein peening is applied in a direction perpendicular to the surface of the coated cutting tool.

6. The method in accordance with any of the preceding claims, wherein the said coating comprises a TiCN layer and an α-Al₂O₃- layer, preferably the thickness of the TiCN layer is 8-12 µm and the thickness of the α-Al₂O₃- layer is 4-8 µm.

7. The method in accordance with any of the preceding claims, wherein the shot peening is followed by a shot blasting step, preferably applied on the same surface(s) of the cutting tool.

8. The method in accordance with any of the preceding claims wherein the peening pressure during the shot peening is 1-3 bar.

9. A cutting tool comprising a substrate of cemented carbide and a coating, wherein the cutting tool comprise a rake face (1), a flank face (2) and a cutting edge (3) there between, wherein the coating comprises in the order from the substrate a TiCN layer, an α-Al₂O₃-layer, wherein the thickness of the TiCN layer is 8-12 µm and the thickness of the α-Al₂O₃-layer is 4-8 µm, wherein the residual stress in said TiCN layer as measured with XRD by a sin²_{Ψ} with integral analyse depth using the (422) peak, is between 0 MPa and 100 MPa, and wherein the residual stress in said α-Al₂O₃- layer as measured with XRD by a sin²Ψ fix depth 2.5 µm method using the (116) peak is between -1000 MPa and -2500 MPa.

10. The coated cutting tool of claim 9, wherein the residual stress in the TiCN layer is between +5 MPa and +75 MPa.

11. The coated cutting tool of claim 9 or 10, wherein the residual stress in the α-Al₂O₃- layer is between -1100 MPa and -2100 MPa

12. The coated cutting tool of any of claims 9-11, wherein ER of at least a part of said cutting edge is 25-70 µm, preferably 40-60 µm, more preferably 50-55 µm.

13. The coated cutting tool of any of claims 9-12, wherein the cemented carbide in the substrate comprise 5-8 wt% Co.

14. The coated cutting tool of any of claims 9 or 13, wherein the absolute value of the difference Δ between the residual stress in TiCN in the cutting tool at room temperature and the residual stress in TiCN of the same cutting tool after being subjected to a heat treatment in 1030°C in Ar for 3 hours is > 100 MPa, preferably > 200 MPa.
